(19) Europäisches Patentamt / European Patent Office / Office européen des brevets

(11) **EP 2 309 547 B1**

(12) **EUROPEAN PATENT SPECIFICATION**

(45) Date of publication and mention
of the grant of the patent:
**12.12.2012 Bulletin 2012/50**

(51) Int Cl.:
*H01L 31/0224* (2006.01)   *H01G 9/20* (2006.01)

(21) Application number: **10174265.8**

(22) Date of filing: **27.08.2010**

(54) **Photoelectric conversion device**

Photoelektrische Umwandlungsvorrichtung

Dispositif de conversion photoélectrique

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **06.10.2009 US 249126 P**

(43) Date of publication of application:
**13.04.2011 Bulletin 2011/15**

(73) Proprietor: **Samsung SDI Co., Ltd.
Suwon-si, Gyeonggi-do 443-731 (KR)**

(72) Inventors:
• **Kang, Moon-Sung
  Gyeonggi-do (KR)**
• **Lee, Ji-Won
  Gyeonggi-Do (KR)**
• **Song, Su-Bin
  Gyeonggi-do (KR)**
• **Jung, Joo-Sik
  Gyeonggi-do (KR)**

(74) Representative: **Gulde Hengelhaupt Ziebig &
Schneider
Patentanwälte - Rechtsanwälte
Wallstrasse 58/59
10179 Berlin (DE)**

(56) References cited:
**WO-A1-2006/051644     GB-A- 2 427 963
US-A1- 2005 034 755     US-A1- 2006 112 988
US-A1- 2007 246 096     US-A1- 2008 083 452**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

BACKGROUND

1. Field

One or more embodiments of the present invention relate to a photoelectric conversion device, and more particularly, to a photoelectric conversion device that may have improved photoelectric conversion efficiency by using a collector electrode.

2. Description of the Related Art

Extensive research has recently been conducted on photoelectric conversion devices that convert light into electric energy. From among such devices, solar cells utilizing sunlight have attracted attention as alternative energy sources to fossil fuels.

As research on solar cells having various working principles has been continuously conducted, wafer-based crystalline silicon solar cells using a p-n semiconductor junction have appeared to be the most prevalent ones. However, the manufacturing costs of wafer-based crystalline silicon solar cells are high because they are formed of a high purity semiconductor material.

Unlike silicon solar cells, dye-sensitized solar cells include a photosensitive dye that receives visible light and generates excited electrons, a semiconductor material that receives the excited electrons, and an electrolyte that reacts with electrons returning from an external circuit. Since dye-sensitized solar cells have much higher photoelectric conversion efficiency than other conventional solar cells, the dye-sensitized solar cells are viewed as the next generation solar cells.

A dye-sensitized solar cell according to the preamble of claim 1 is known for example from document US 2007/0246096 A1.

SUMMARY

One or more embodiments of the present invention include a photoelectric conversion device that may have improved photoelectric conversion efficiency.

According to one or more embodiments of the present invention, there is provided a photoelectric conversion device comprising: a first substrate; a second substrate opposing the first substrate; a first electrode formed on the first substrate; a second electrode formed on the second substrate; an electrolyte layer interposed between the first electrode and the second electrode; and a semiconductor layer in which a photosensitive dye is adsorbed, wherein the semiconductor layer is interposed between the electrolyte layer and the first electrode; wherein the first electrode comprises a grid electrode, the grid electrode comprising a plurality of finger electrodes extending parallel to each other, wherein the finger electrodes satisfy condition (I): $0.0125 \leq W/P \leq 0.0167$, wherein W is the line width of the finger electrodes and P is a minimum distance between adjacent finger electrodes.

Preferably the line width W of the finger electrodes satisfy condition (II): $W \leq 0.2$ mm. Preferably the line width W of the finger electrodes satisfy condition (III): $W \leq 0.5$ mm. Preferably the second electrode comprises a grid electrode, the grid electrode comprising a plurality of finger electrodes extending parallel to each other, wherein the finger electrodes of the grid electrode of the second electrode satisfy at least one of condition (I), condition (II), and condition (III). Preferably the finger electrodes of the grid electrode of the second electrode satisfy at least two conditions of condition (I), condition (II) and condition (III). Preferably the finger electrodes of the grid electrode of the second electrode satisfy all three conditions of condition (I), condition (II) and condition (III). Preferably the first electrode further comprises a transparent conductive layer being disposed between the first substrate and the grid electrode. Preferably the counter electrode comprises a transparent conductive layer and a catalyst layer formed on the transparent conductive layer. Preferably the transparent conductive layer is formed of a material selected from the group of indium tin oxide, fluorine tin oxide and antimony-doped tin oxide; and/or wherein the grid electrode is formed of a material having electrical conductivity of greater than $20 *10^6$ S m$^{-1}$.

Preferably at least one of the grid electrode of the first electrode and the grid electrode of the second electrode comprises a protection layer, wherein the protection layer is formed on a surface of the grid electrode which is not in direct contact with the transparent conductive layer.

Preferably at least one of the grid electrode of the first electrode and the grid electrode of the second electrode further comprises a bus bar being connected to end portions of the plurality of finger electrodes, wherein the longitudinal axis of the bus bar extends perpendicular to the longitudinal axes of the plurality of finger electrodes.

Preferably the finger electrodes and/or the bus bar extend parallel to edges of the first substrate. Preferably the finger electrodes comprise a longish stripe shape, the finger electrodes have a uniform thickness, the bus bar comprises a longish stripe shape. Preferably the finger electrodes are arranged to be equidistant to each other.

Preferably the finger electrodes extend over a distance of at least 80% of the distance between edges of the first substrate which extend perpendicular to the finger electrodes. Preferably the bus bar extends over a distance of at least 80% of the distance between edges of the first substrate which extend perpendicular to the bus bar.

Preferably a projection of the finger electrodes of the first electrode to the first substrate along an axis perpendicular to the surface of the first substrate is congruent with a projection of the finger electrodes of the second electrode to the first substrate. Preferably the finger electrodes of the first electrode and the finger electrodes of the second electrode are formed of the same material. Preferably the finger electrodes of the first electrode and the finger electrodes of the second electrode have the same line width and the same distance between adjacent finger electrodes.

BRIEF DESCRIPTION OF THE DRAWINGS

These and/or other aspects will become apparent and more readily appreciated from the following description of the embodiments, taken in conjunction with the accompanying drawings of which:

FIG. 1 is a cross-sectional view of a photoelectric conversion device according to an embodiment of the present invention;

FIG. 2 is a plan view of a light receiving substrate of the photoelectric conversion device of FIG. 1 on which a photoelectrode is formed;

FIG. 3 is a circuit diagram for explaining a model of the photoelectrode of FIG. 2;

FIG. 4 is a circuit diagram for calculating one equivalent resistance from the model of the photoelectrode of FIG. 3;

FIG. 5 is a graph illustrating a relationship between the equivalent resistance of the photoelectrode and the line width of a grid electrode;

FIG. 6 is a circuit diagram illustrating a relationship between the aperture ratio of a light receiving substrate and a ratio of the line width of the grid electrode to the pitch of the grid electrode;

FIG. 7 is a graph illustrating a relationship between photoelectric conversion efficiency and the ratio between the line width of the grid electrode and the pitch of the grid electrode; and

FIG. 8 is a cross-sectional view of a photoelectric conversion device according to an embodiment of the present invention.

DETAILED DESCRIPTION

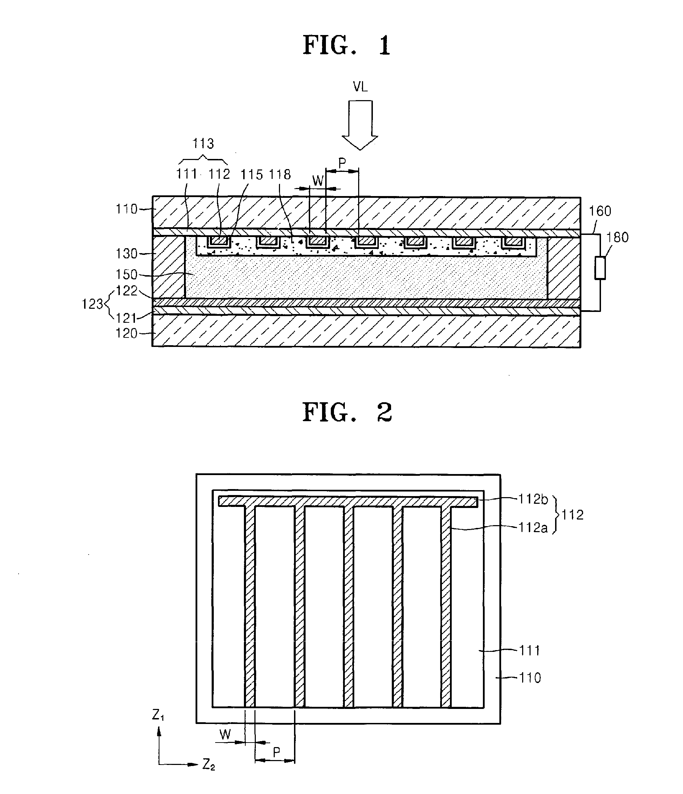

One or more embodiments of the present invention will now be described with reference to the attached drawings. FIG. 1 is a cross-sectional view of a photoelectric conversion device according to an embodiment of the present invention. Referring to FIG. 1, a light receiving substrate 110 on which a photoelectrode 113 is formed and a counter substrate 120 on which a counter electrode 123 is formed facing the photoelectrode 113. A semiconductor layer 118 adsorbing a photosensitive dye that is excited by light VL is formed on the photoelectrode 113. An electrolyte layer 150 is disposed between the semiconductor layer 118 and the counter electrode 123.

The light receiving substrate 110 and the counter substrate 120 are attached to each other using a sealing material 130 in such a manner that an interval is formed therebetween. An electrolyte solution used for the electrolyte layer 150 may be filled between the light receiving substrate 110 and the counter substrate 120. The photoelectrode 113 and the counter electrode 123 are electrically connected to each other using a wire 160 through an external circuit 180. In a module in which a plurality of photoelectric conversion devices are connected in series or in parallel, photoelectrodes and counter electrodes of the plurality of photoelectric conversion devices may be connected in series or in parallel, and both ends of the connecting portions may be connected to the external circuit 180.

The light receiving substrate 110 may be formed of a transparent material, preferably, a material having a high light transmittance. For example, the light receiving substrate 110 may be a glass substrate or a resin film substrate. Since a resin film usually has flexibility, the resin film may be applied to devices requiring flexibility.

The photoelectrode 113 may include a transparent conductive layer 111 and a grid electrode 112 formed in a mesh pattern on the transparent conductive layer 111. The transparent conductive layer 111 is formed of a material having transparency and electrical conductivity, for example, a transparent conductive oxide such as indium tin oxide (ITO), fluorine tin oxide (FTO), or antimony-doped tin oxide (ATO). The grid electrode 112 is used to reduce the electrical resistance of the photoelectrode 113, and functions as a collector wire that collects electrons generated by photoelectric conversion and provides a current path having a low resistance. For example, the grid electrode 112 may be formed of a metal material having high electrical conductivity, such as gold (Ag), silver (Au), or aluminum (Al), and may be patterned in a mesh fashion.

The photoelectrode 113 functions as a cathode of the photoelectric conversion device and may have a high aperture ratio. Since light VL incident through the photoelectrode 113 excites the photosensitive dye adsorbed into the semiconductor layer 118, the photoelectric conversion efficiency may be improved when the amount of incident light VL is increased. The term 'aperture ratio' is a ratio of an effective light transmitting area to the overall area of the light receiving substrate 110 on which the photoelectrode 113 is coated. Since the grid electrode 112 is usually formed of an opaque material, e.g., a metal material, the aperture ratio decreases as the area of the grid electrode 112 increases. Since a line width W of the grid electrode 112 limits the effective light transmitting area, the line width W of the grid electrode 112 needs to be small. However, since the grid electrode 112 is used to reduce the electrical resistance of the photoelectrode 113, for example, a pitch P of the grid electrode 112, which is an interval from adjacent grid electrode segments of the grid electrode 112 made by the mesh pattern, needs to be small as well in order to compensate for an increase in the electrical resistance of the photoelectrode 113 caused when the line width W of the grid electrode 112 is small.

A protective layer 115 may be further formed on an outer surface of the grid electrode 112, i.e. surface of the grid electrode 112 which is not in direct contact with the transparent conductive layer 111. The protective layer 115 prevents the grid electrode 112 from being damaged, for example, from being eroded, when the grid electrode 112 contacts and reacts with the electrolyte layer 150. The protective layer 115 may be formed of a material that does not react with the electrolyte layer 150, for example, a curable resin material.

The semiconductor layer 118 may be formed of a metal oxide comprising a metal such as Cd, Zn, In, Pb, Mo, W, Sb, Ti, Ag, Mn, Sn, Zr, Sr, Ga, Si, or Cr. The semiconductor layer 118 may increase the photoelectric conversion efficiency by adsorbing the photosensitive dye. For example, the semiconductor layer 118 may be formed by coating a paste of semiconductor particles having a particle diameter of 5 to 1000 nm on the light receiving substrate 110 on which the photoelectrode 113 is formed and applying heat or pressure to a resultant structure.

The photosensitive dye adsorbed into the semiconductor layer 118 absorbs light VL passing through the light receiving substrate 110, so that electrons of the photosensitive dye are excited from a ground state. The excited electrons are transferred to the conduction band of the semiconductor layer 118 through electrical contact between the photosensitive dye and the semiconductor layer 118, then from the conduction band of the semiconductor layer 118 to the photoelectrode 113, and then the electrons are discharged to the outside through the photoelectrode 113, thereby forming a driving current for driving the external circuit 180.

For example, the photosensitive dye adsorbed into the semiconductor layer 118 may consist of molecules that absorb light VL and excite electrons so as to allow the excited electrons to be rapidly moved to the semiconductor layer 118. The photosensitive dye may be any one of liquid type, semi-solid gel type, and solid type photosensitive dyes. For example, the photosensitive dye adsorbed into the semiconductor layer 118 may be a ruthenium-based photosensitive dye. The semiconductor layer 118 adsorbing the photosensitive dye may be obtained by dipping the light receiving substrate 110 on which the semiconductor layer 118 is formed in a solution including the photosensitive dye.

The electrolyte layer 150 may be formed of a redox electrolyte including reduced/oxidized (R/O) couples. The electrolyte layer 150 may be formed of any one of solid type, gel type, and liquid type electrolytes.

The counter substrate 120 facing the light receiving substrate 110 is not necessarily transparent. However, in order to increase photoelectric conversion efficiency, the counter substrate 120 may be formed of a transparent material that receives light VL on both sides of the photoelectric conversion device, and may be formed of the same material as that of the light receiving substrate 110. In particular, if the photoelectric conversion device is installed as a building integrated photovoltaic system in a structure, e.g., a window frame, both sides of the photoelectric conversion device may be transparent so that light VL introduced into the inside of a building is prevented from being blocked.

The counter electrode 123 may include a transparent conductive layer 121 and a catalyst layer 122 formed on the transparent conductive layer 121. The transparent conductive layer 121 is formed of a material having transparency and electrical conductivity, for example, a transparent conductive oxide such as ITO, FTO, orATO. The catalyst layer 122 is formed of a reduction catalyzing material for providing electrons to the electrolyte layer 150, for example, a metal such as platinum (Pt), gold (Ag), silver (Au), copper (Cu), or aluminum (Al), a metal oxide such as a tin oxide, or a carbon-based material such as graphite.

The counter electrode 123 functions as an anode of the photoelectric conversion device, and also as a reduction catalyst for providing electrons to the electrolyte layer 150. The photosensitive dye adsorbed into the semiconductor layer 118 absorbs light VL to excite electrons, and the excited electrons are discharged to the outside of the photoelectric conversion device through the photoelectrode 113. The photosensitive dye losing the electrons receives electrons generated by oxidization of the electrolyte layer 150 to be reduced again, and the oxidized electrolyte layer 150 is reduced again by electrons passing through the external circuit 180 and reaching the counter electrode 123, thereby completing the operation of the photoelectric conversion device.

FIG. 2 is a plan view of the light receiving substrate 110 on which the photoelectrode 113 is formed. Referring to FIG. 2, the grid electrode 112 which is patterned in a shape is formed on the transparent conductive layer 111. The grid electrode 112 may include finger electrodes 112a extending in stripes in one direction $Z_1$, and a bus bar 112b extending to cross the finger electrodes 112a and adapted to collect electrons from the finger electrodes 112a and discharge the collected electrons to the outside of the photoelectric conversion device. Reference symbols P and W denote the pitch and the line width of the finger electrodes 112a, respectively. According to the present invention, the expression "pitch of the finger electrodes" is understood as a minimum distance between two adjacent and parallel finger electrodes, in more particular a minimum distance between the outer edges of two parallel adjacent finger electrodes, wherein the outer edges are facing towards each other.

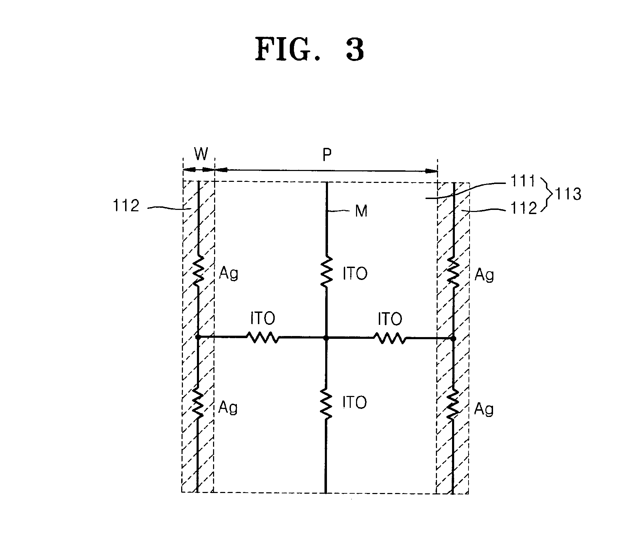

FIG. 3 is a circuit diagram for explaining a model of the photoelectrode 113 of FIG. 2. Referring to FIG. 3, the photoelectrode 113 includes a grid-type current path M, and resistors ITO and Ag disposed on the current path M. The current path M is a path through which electrons generated by photoelectric conversion pass through the transparent conductive layer 111 and move to the grid electrode 112. The current path M simplifies the network structure of the grid electrode segments of the grid electrode 112 and the transparent conductive layer 111 between the grid electrode segments of the grid electrode 112. The resistors ITO and Ag indicate resistor components of the grid electrode 112 and the transparent conductive layer 111. For example, the resistors ITO and Ag have the resistivity of the resistor ITO corresponding to the transparent conductive layer 111 and the resistivity of the resistor Ag corresponding to the grid electrode 112. The electrical resistance of each of the resistors ITO and Ag may be calculated by multiplying each resistivity by the pitch P or the line width W of the grid electrode 112. For example, the length of the resistor ITO corresponding to the transparent conductive layer 111 varies according to the pitch P of the grid electrode 112, and the electrical resistance of the resistor ITO is determined by multiplying the resistivity of the resistor ITO by the length of the resistor ITO. Also, the width of the resistor Ag corresponding to the grid electrode 112 varies according to the line width W of the grid electrode 112, and the electrical resistance of the resistor Ag is determined by multiplying the resistivity of the resistor Ag by the width of the resistor Ag.

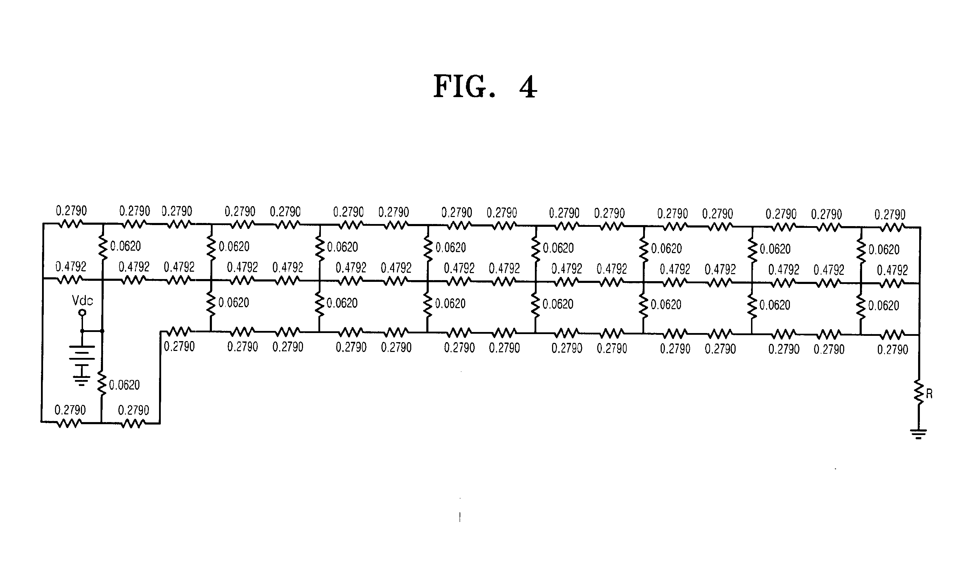

In FIG. 3, when the light receiving substrate 110 on which the photoelectrode 113 is formed has an area of 100 mm x 100 mm, the equivalent resistance of the photoelectrode 113 is calculated while varying the pitch P and the line width W of the grid electrode 112 and the transparent conductive layer 111 and fixing the thickness of the grid electrode 112 to a certain value. FIG. 4 is a circuit diagram for calculating one equivalent resistance from the model of the photoelectrode 113 of FIG. 3 under a given condition. For example, the equivalent resistance of the photoelectrode 113 may be calculated using a current value that is obtained by inputting the model of the photoelectrode 113 to OrCAD-PSpice, applying a voltage Vdc of 1V to one node, and connecting an external unit having a load resistance R of 1 $\Omega$ between the model of the photoelectrode 113 and the ground.

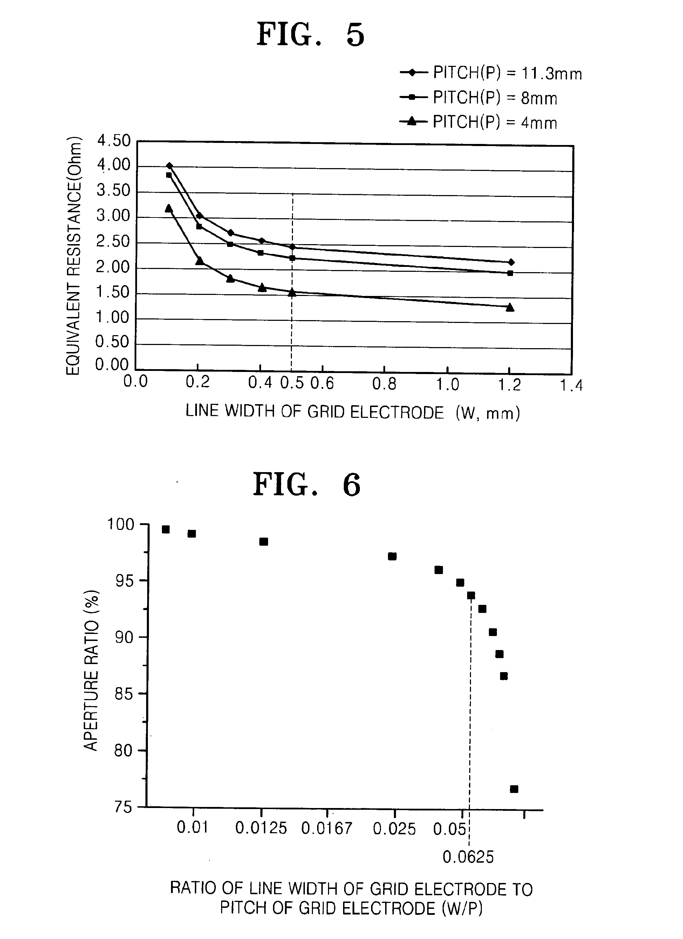

FIG. 5 is a graph illustrating a relationship between the equivalent resistance of the photoelectrode 113 and the line width W of the grid electrode 112. In FIG. 5, the pitch P of the grid electrode 112 is 4 mm, 8 mm, and 11.3 mm. Referring to FIG. 5, the equivalent resistance of the photoelectrode 113 increases as the line width W of the grid electrode 112 decreases. In particular, the equivalent resistance sharply decreases when the line width W is smaller than 0.5 mm. Accordingly, the line width W may be limited to a value of at least greater than 0.5 mm.

As apparent from FIG. 5, in order to increase the collection efficiency and reduce the electrical resistance of the photoelectrode 113, the line width W of the grid electrode 112 needs to be increased. In contrast, in order to increase the aperture ratio of the light receiving substrate 110 and increase an effective light transmitting area, the line width W of the grid electrode 112 that is opaque needs to be decreased. Accordingly, the line width W of the grid electrode 112 needs to be appropriately determined so as to increase photoelectric conversion efficiency.

The design of the grid electrode 112 directly affects the aperture ratio of the light receiving substrate 110. In particular, when the light receiving substrate 110 has a fixed area, the pitch P and the line width W of the grid electrode 112 may determine the aperture ratio of the light receiving substrate 110. FIG. 6 is a graph illustrating a relationship between the aperture ratio of the light receiving substrate 110 and a ratio W/P of the line width W of the grid electrode 112 to the pitch P of the grid electrode 112 when the light receiving substrate 110 has a fixed area. In FIG. 6, the ratio W/P is set as a new design parameter.

Referring to FIG. 6, the aperture ratio of the light receiving substrate 110 varies according to the ratio W/P. That is, the aperture ratio increases as the ratio W/P decreases, and the aperture ratio decreases as the ratio W/P increases. In other words, as the line width W of the grid electrode 112 decreases and the pitch P increases, the aperture ratio of the light receiving substrate 110 increases. On the contrary, as the line width W of the grid electrode 112 increases and the pitch P decreases, the aperture ratio decreases. In particular, since the aperture ratio of the light receiving substrate 110 drastically decreases when the ratio W/P is about 0.0625, the ratio W/P may be limited to a value smaller than 0.0625.

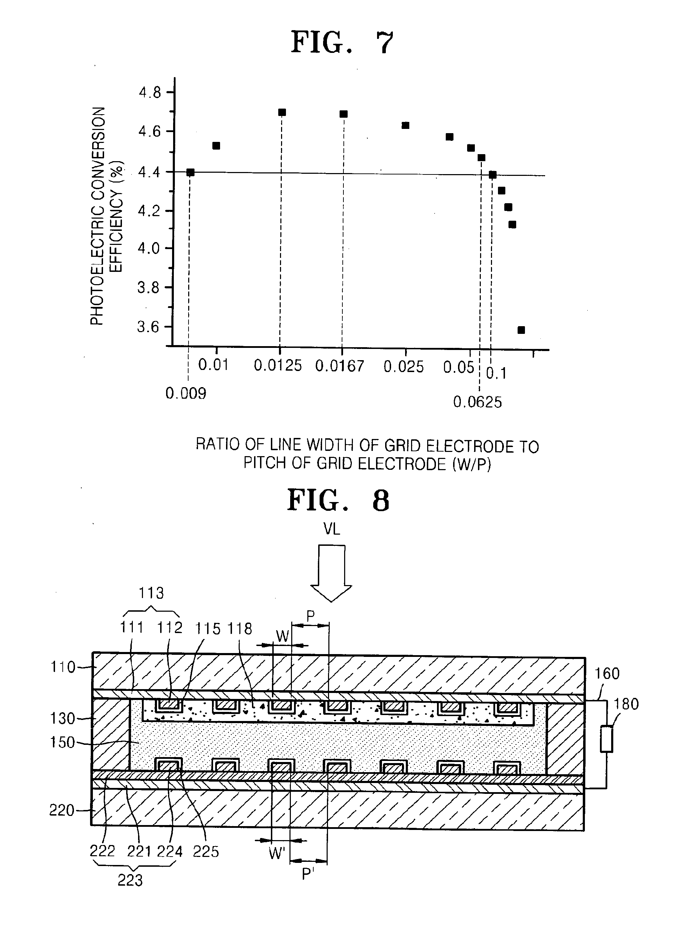

FIG. 7 is a graph illustrating a relationship between photoelectric conversion efficiency $\eta$ and the ratio W/P between the line width W of the grid electrode 112 and the pitch P of the grid electrode 112. The photoelectric conversion efficiency $\eta$ may be calculated using Equation 1 as shown below by using the intensity of incident light Po (mW/cm$^2$) that is an input to the photoelectric conversion device, an open voltage Voc (V) at an output terminal of the photoelectric conversion device, a shortcut current density Jsc (mA/cm$^2$), and a fill-factor FF.

[Equation 1]

$$\eta = 100 \times (V_{oc} \times J_{sc} \times FF)/P_o$$

Referring to FIG. 7, the photoelectric conversion efficiency varies according to the ratio W/P between the line width W of the grid electrode 112 and the pitch P of the grid electrode 112. In particular, the photoelectric conversion efficiency is the highest, about 4.7 %, when the ratio W/P is 0.0125, and the photoelectric conversion efficiency decreases from the peak of 4.7 %. When the ratio W/P is greater than 0.0125, the photoelectric conversion efficiency decreases as the ratio W/P increases. Such a profile is similar to that of the graph of FIG. 6. This is because the aperture ratio of the light receiving substrate 110 directly affects the photoelectric conversion efficiency so that the photoelectric conversion efficiency varies depending on the aperture ratio. In particular, since the photoelectric conversion efficiency drastically decreases when the ratio W/P is about 0.0625, the ratio W/P may be limited to a value smaller than 0.0625.

When the ratio W/P is smaller than 0.0125, the photoelectric conversion efficiency drastically decreases as the ratio W/P decreases. This is because if the ratio W/P is below an appropriate level, the electrical resistance of the photoelectrode 113 increases, thereby limiting the photoelectric conversion efficiency. That is, when the ratio W/P is low, the line width W of the grid electrode 112 is small and the pitch P is large, the area of the grid electrode 112 is reduced and the electrical resistance of the photoelectrode 113 is increased. Accordingly, the ratio W/P may be limited to a value of at least greater than 0.0125.

In conclusion, the ratio W/P between the line width W of the grid electrode 112 and the pitch P of the grid electrode 112 may be determined to satisfy $0.0125 \leq W/P \leq 0.0625$. If the ratio W/P is greater than the upper limit of 0.0625, the aperture ratio of the light receiving substrate 110 is limited, thereby lowering the photoelectric conversion efficiency. If the ratio W/P is smaller than the lower limit of 0.0125, the electrical conductivity of the photoelectrode 113 is limited, thereby lowering the photoelectric conversion efficiency.

FIG. 8 is a cross-sectional view of a photoelectric conversion device according to another embodiment of the present invention. Referring to FIG. 8, the light receiving substrate 110 on which the photoelectrode 113 is formed, the semiconductor layer 118 adsorbing a photosensitive dye, the electrolyte layer 150, and the counter substrate 220 on which the counter electrode 223 is formed are sequentially disposed in a direction in which light VL is incident. The photoelectrode 113 includes the transparent conductive layer 111, and the grid electrode 112 formed in a mesh pattern on the transparent conductive layer 111. The counter electrode 223 facing the photoelectrode 113 includes a transparent conductive layer 221, a catalyst layer 222 formed on the transparent conductive layer 221, and a grid electrode 224 formed in a mesh pattern on the catalyst layer 222.

The photoelectric conversion device of FIG. 8 is different from the photoelectric conversion device of FIG. 1 in that the grid electrode 224 is formed on the counter electrode 223 as well as the photoelectrode 113. The grid electrode 224 is used to reduce the electrical resistance of the counter electrode 223, and provides a current path having a low resistance for collecting electrons passing through the external circuit 180 and reaching the counter electrode 223 and sending the electrons to the electrolyte layer 150. For example, the grid electrode 224 may be formed of a metal material having high electrical conductivity, such as gold (Ag), silver (Au), or aluminum (Al), and may be patterned in a mesh fashion.

A protective layer 225 may be further formed on an outer surface of the grid electrode 224. The protective layer 225 prevents the grid electrode 224 from being damaged, for example, from being eroded when the grid electrode 224 contacts and reacts with the electrolyte layer 150. The protective layer 225 may be formed of a material that does not react with the electrolyte layer 150, for example, a curable resin material.

The technical contents about the photoelectric conversion efficiency, the aperture ratio, and the electrical characteristics of the photoelectrode 113 of FIGS. 5 through 7 may be applied to the counter electrode 223 as well as the photoelectrode 113. That is, according to the technical contents described with reference to FIGS. 5 through 7, the counter electrode 223 is designed to improve the photoelectric conversion efficiency, a pitch P' and a line width W' of the grid electrode 224 included in the counter electrode 223 may be appropriately determined.

According to the one or more embodiments of the present invention, an electrode for collecting electrons generated by photoelectric conversion is designed to improve photoelectric conversion efficiency. That is, the shape and arrangement of a grid electrode directly affecting the aperture ratio and resistance of a substrate is appropriately determined. By using a new design parameter corresponding to a relationship between the line width of a grid electrode and the pitch of the grid electrode, and a new design range allowing high photoelectric conversion efficiency, a photoelectric conversion device with high efficiency may be provided.

While the present invention has been particularly shown and described with reference to exemplary embodiments thereof, it will be understood by those of ordinary skill in the art that various changes in form and details may be made therein without departing from the scope as defined by the following claims.

**Claims**

1. A photoelectric conversion device comprising:

   a first substrate (110);
   a second substrate (120) opposing the first substrate (110);
   a first electrode (113) formed on the first substrate (110);
   a second electrode (123) formed on the second substrate (120);
   an electrolyte layer (150) interposed between the first electrode (113) and the second electrode (123); and
   a semiconductor layer (118) in which a photosensitive dye is adsorbed, wherein
   the semiconductor layer (118) is interposed between the electrolyte layer (150) and the first electrode (113);
   wherein the first electrode (113) comprises a grid electrode (112), the grid electrode (112) comprising a plurality
   of finger electrodes (112a) extending parallel to each other,
   **characterized in that**
   the finger electrodes (112a) satisfy condition (I):

$$\text{(I)} \qquad 0.0125 \leq W/P \leq 0.0167 \, ,$$

   wherein W is the line width of the finger electrodes (112a) and P is a minimum distance between adjacent finger
   electrodes (112a).

2. The photoelectric conversion device according to claim 1, wherein the line width W of the finger electrodes (112a)
   satisfy condition (II):

$$\text{(II)} \qquad W \geq 0.2 \, \text{mm}.$$

3. The photoelectric conversion device according to one of the preceding claims, wherein the line width W of the finger
   electrodes (112a) satisfy condition (III):

$$\text{(III)} \qquad W \geq 0.5 \, \text{mm}.$$

4. The photoelectric conversion device according to any one of the preceding claims, wherein the second electrode
   (223) comprises a grid electrode (224), the grid electrode (224) comprising a plurality of finger electrodes extending
   parallel to each other, wherein the finger electrodes of the grid electrode (224) of the second electrode (223) satisfy
   at least one of condition (I), condition (II), and condition (III).

5. The photoelectric conversion device according to any one of the preceding claims, wherein first electrode (113)
   further comprises a transparent conductive layer (111) being disposed between the first substrate (110) and the
   grid electrode (112) and/or wherein the second electrode (123) comprises a transparent conductive layer (121) and
   a catalyst layer (122) formed on the transparent conductive layer (121).

6. The photoelectric conversion device according to claim 5, wherein the transparent conductive layer (111, 121) is
   formed of a material selected from the group of indium tin oxide, fluorine tin oxide and antimony-doped tin oxide.

7. The photoelectric conversion device according to claim 5, wherein the grid electrode (112, 224) is formed of a
   material having electrical conductivity of greater than 20 $\ast 10^6$ S m$^{-1}$.

8. The photoelectric conversion device according to any one of the preceding claims, wherein at least one of the grid
   electrode (112) of the first electrode (113) and the grid electrode (224) of the second electrode (223) comprises a
   protection layer (115, 225), wherein the protection layer (115, 225) is formed on a surface of the grid electrode (112, 224) which is not in direct contact with the transparent conductive layer (111, 121).

9. The photoelectric conversion device according to any one of the preceding claims, wherein at least one of the grid electrode (112) of the first electrode (113) and the grid electrode (224) of the second electrode (223) further comprises a bus bar (112b) being connected to end portions of the plurality of finger electrodes (112a), wherein the longitudinal axis of the bus bar (112b) extends perpendicular to the longitudinal axes of the plurality of finger electrodes (112a).

10. The photoelectric conversion device according to any one of the preceding claims, wherein the finger electrodes (112a) and/or the bus bar (112b) extend parallel to edges of the first substrate (110).

11. The photoelectric conversion device according to any one of the preceding claims, wherein the finger electrodes (112a) comprise a longish stripe shape, the finger electrodes (112a) have a uniform thickness, the bus bar (112b) comprises a longish stripe shape and/or the finger electrodes (112a) are arranged to be equidistant to each other.

12. The photoelectric conversion device according to any one of the preceding claims, wherein the finger electrodes (112a) extend over a distance of at least 80% of the distance between edges of the first substrate (110) which extend perpendicular to the finger electrodes (112a) and/or wherein the bus bar (112b) extends over a distance of at least 80% of the distance between edges of the first substrate (110) which extend perpendicular to the bus bar (112b).

13. The photoelectric conversion device according to any one of claims 4 to 12, wherein a projection of the finger electrodes (112a) of the first electrode (113) to the second substrate (120) along an axis perpendicular to the surface of the second substrate (120) is congruent with a projection of the finger electrodes of the second electrode (223) to the second substrate (120).

14. The photoelectric conversion device according to any one of claims 4 to 13, wherein the finger electrodes (112a) of the first electrode (113) and the finger electrodes of the second electrode (223) are formed of the same material and/or wherein the finger electrodes (112a) of the first electrode (113) and the finger electrodes of the second electrode (223) have the same line width and the same distance between adjacent finger electrodes.

**Patentansprüche**

1. Photoelektrische Umwandlungsvorrichtung, umfassend:

ein erstes Substrat (110);
ein dem ersten Substrat (110) gegenüberliegendes zweites Substrat (120);
eine auf dem ersten Substrat (110) ausgebildete erste Elektrode (113);
eine auf dem zweiten Substrat (120) ausgebildete zweite Elektrode (123);
eine zwischen die erste Elektrode (113) und die zweite Elektrode (123) geschaltete Elektrolytschicht (150); und
eine Halbleiterschicht (118), in der ein lichtsensitiver Farbstoff absorbiert ist, wobei die Halbleiterschicht (118) zwischen die Elektrolytschicht (150) und die erste Elektrode (113) geschaltet ist;
wobei die erste Elektrode (113) eine Gitterelektrode (112) umfasst, wobei die Gitterelektrode (112) eine Vielzahl von sich parallel zueinander erstreckenden Fingerelektroden (112a) umfasst,
**dadurch gekennzeichnet, dass**
die Fingerelektroden (112a) Bedingung (I) erfüllen:

$$(I) \qquad 0,0125 \leq W/P \leq 0,0167,$$

wobei W die Leitungsbreite der Fingerelektroden (112a) ist und P ein minimaler Abstand zwischen benachbarten Fingerelektroden (112a) ist.

2. Photoelektrische Umwandlungsvorrichtung nach Anspruch 1, wobei die Leitungsbreite W der Fingerelektroden (112a) Bedingung (II) erfüllt:

$$(\text{II}) \qquad W \geq 0,2 \text{ mm}.$$

3. Photoelektrische Umwandlungsvorrichtung nach einem der vorstehenden Ansprüche, wobei die Leitungsbreite W der Fingerelektroden (112a) Bedingung (III) erfüllt:

$$(\text{III}) \qquad W \geq 0,5 \text{ mm}.$$

4. Photoelektrische Umwandlungsvorrichtung nach einem der vorstehenden Ansprüche, wobei die zweite Elektrode (223) eine Gitterelektrode (224) umfasst, wobei die Gitterelektrode (224) eine Vielzahl von sich parallel zueinander erstreckenden Fingerelektroden umfasst, wobei die Fingerelektroden der Gitterelektrode (224) der zweiten Elektrode (223) mindestens eine der Bedingung (I), der Bedingung (II) und der Bedingung (III) erfüllen.

5. Photoelektrische Umwandlungsvorrichtung nach einem der vorstehenden Ansprüche, wobei die erste Elektrode (113) ferner eine transparente leitende Schicht (111) umfasst, die zwischen dem ersten Substrat (110) und der Gitterelektrode (112) angeordnet ist, und/oder wobei die zweite Elektrode (123) eine transparente leitende Schicht (121) sowie eine auf der transparenten leitenden Schicht (121) ausgebildete Katalysatorschicht (122) umfasst.

6. Photoelektrische Umwandlungsvorrichtung nach Anspruch 5, wobei die transparente leitende Schicht (111, 121) aus einem Material ausgewählt aus der Gruppe Indium-Zinnoxid, Fluor-Zinnoxid und antimondotiertem Zinnoxid gebildet ist.

7. Photoelektrische Umwandlungsvorrichtung nach Anspruch 5, wobei die Gitterelektrode (112, 224) aus einem Material mit einer elektrischen Leitfähigkeit von größer als $20 *10^6$ S m$^{-1}$ gebildet ist.

8. Photoelektrische Umwandlungsvorrichtung nach einem der vorstehenden Ansprüche, wobei mindestens eine der Gitterelektrode (112) der ersten Elektrode (113) und der Gitterelektrode (224) der zweiten Elektrode (223) eine Schutzschicht (115, 225) umfasst, wobei die Schutzschicht (115, 225) auf einer Fläche der Gitterelektrode (112, 224) ausgebildet ist, die nicht in direktem Kontakt mit der transparenten leitenden Schicht (111, 121) steht.

9. Photoelektrische Umwandlungsvorrichtung nach einem der vorstehenden Ansprüche, wobei mindestens eine der Gitterelektrode (112) der ersten Elektrode (113) und der Gitterelektrode (224) der zweiten Elektrode (223) ferner eine mit Endabschnitten der Vielzahl von Fingerelektroden (112b) verbundene Sammelschiene (112b) umfasst, wobei die Längsachse der Sammelschiene (112b) senkrecht zu den Längsachsen der Vielzahl von Fingerelektroden (112a) verläuft.

10. Photoelektrische Umwandlungsvorrichtung nach einem der vorstehenden Ansprüche, wobei die Fingerelektroden (112a) und/oder die Sammelschiene (112b) parallel zu Rändern des ersten Substrats (110) verlaufen.

11. Photoelektrische Umwandlungsvarrichtung nach einem der vorstehenden Ansprüche, wobei die Fingerelektroden (112a) eine längliche Streifenform aufweisen, die Fingerelektroden (112a) eine einheitliche Dicke aufweisen, die Sammelschiene (112b) einen längliche Streifenform aufweist und/oder die Fingerelektroden (112a) mit gleichem Abstand zueinander angeordnet sind.

12. Photoelektrische Umwandlungsvorrichtung nach einem der vorstehenden Ansprüche, wobei sich die Fingerelektroden (112a) über eine Entfernung von mindestens 80% des Abstandes zwischen Rändern des ersten Substrats (110), die senkrecht zu den Fingerelektroden (112a) verlaufen, erstrecken, und/oder wobei sich die Sammelschiene (112b) über eine Entfernung von mindestens 80% des Abstandes zwischen Rändern des ersten Substrats (110), die senkrecht zu der Sammelschiene (112b) verlaufen, erstreckt.

13. Photoelektrische Umwandlungsvorrichtung nach einem der Ansprüche 4 bis 12, wobei eine Projektion der Fingerelektroden (112a) der ersten Elektrode (113) auf das zweite Substrat (120) entlang einer senkrecht zur Fläche des zweiten Substrats (120) liegenden Achse mit einer Projektion der Fingerelektroden der zweiten Elektrode (223) auf das zweite Substrat (120) übereinstimmt.

**14.** Photoelektrische Umwandlungsvorrichtung nach einem der Ansprüche 4 bis 13, wobei die Fingerelektroden (112a) der ersten Elektrode (113) und die Fingerelektroden der zweiten Elektrode (223) aus demselben Material gebildet sind, und/oder wobei die Fingerelektroden (112a) der ersten Elektrode (113) und die Fingerelektroden der zweiten Elektrode (223) die gleiche Leitungsbreite und den gleichen Abstand zwischen benachbarten Fingerelektroden aufweisen.

**Revendications**

**1.** Dispositif de conversion photoélectrique comprenant :

un premier substrat (110) ;
un second substrat (120) opposé au premier substrat (110) ;
une première électrode (113) formée sur le premier substrat (110) ;
une seconde électrode (123) formée sur le second substrat (120) ;
une couche d'électrolyte (150) interposée entre la première électrode (113) et la seconde électrode (123) ; et
une couche semi-conductrice (118) dans laquelle est adsorbé un colorant photosensible, la couche semi-conductrice (118) étant interposée entre la couche d'électrolyte (150) et la première électrode (113) ;
dans lequel la première électrode (113) comprend une électrode de grille (112), l'électrode de grille (112) comprenant une pluralité d'électrodes de doigt (112a) s'étendant parallèlement les unes aux autres,
**caractérisé en ce que**
les électrodes de doigt (112a) satisfont à la condition (I) :

$$(I) \quad 0,0125 \leq W/P \leq 0,0167,$$

où W est la largeur de ligne des électrodes de doigt (112a) et P est une distance minimale entre des électrodes de doigt adjacentes (112a).

**2.** Dispositif de conversion photoélectrique selon la revendication 1, dans lequel la largeur de ligne W des électrodes de doigt (112a) satisfait à la condition (II) :

$$(II) \quad W \geq 0,2 \ mm.$$

**3.** Dispositif de conversion photoélectrique selon l'une quelconque des revendications précédentes, dans lequel la largeur W de ligne des électrodes de doigt (112a) satisfait à la condition (III) :

$$(III) \quad W \leq 0,5 \ mm.$$

**4.** Dispositif de conversion photoélectrique selon l'une quelconque des revendications précédentes, dans lequel la seconde électrode (223) comprend une électrode de grille (224), l'électrode de grille (224) comprenant une pluralité d'électrodes de doigt s'étendant parallèlement les unes aux autres, dans lequel les électrodes de doigt de l'électrode de grille (224) de la seconde électrode (223) satisfont à au moins l'une de la condition (I), de la condition (II), et de la condition (III).

**5.** Dispositif de conversion photoélectrique selon l'une quelconque des revendications précédentes, dans lequel la première électrode (113) comprend en outre une couche conductrice transparente (111) qui est disposée entre le premier substrat (110) et l'électrode de grille (112) et/ou dans lequel la seconde électrode (123) comprend une couche conductrice transparente (121) et une couche de catalyseur (122) formée sur la couche conductrice transparente (121).

**6.** Dispositif de conversion photoélectrique selon la revendication 5, dans lequel la couche conductrice transparente (111, 121) est formée d'un matériau choisi dans le groupe comprenant l'oxyde d'indium et d'étain, l'oxyde d'étain fluoré et l'oxyde d'étain dopé par de l'antimoine.

7. Dispositif de conversion photoélectrique selon la revendication 5, dans lequel l'électrode de grille (112, 224) est formée d'un matériau ayant une conductivité électrique supérieure à 20*10$^6$ S m$^{-1}$.

8. Dispositif de conversion photoélectrique selon l'une quelconque des revendications précédentes, dans lequel au moins l'une de l'électrode de grille (112) de la première électrode (113) et de l'électrode de grille (224) de la seconde électrode (223) comprend une couche de protection (115, 225), dans lequel la couche de protection (115, 225) est formée sur une surface de l'électrode de grille (112, 224) qui n'est pas en contact direct avec la couche conductrice transparente (111, 121).

9. Dispositif de conversion photoélectrique selon l'une quelconque des revendications précédentes, dans lequel au moins l'une de l'électrode de grille (112) de la première électrode (113) et de l'électrode de grille (224) de la seconde électrode (223) comprend en outre une barre omnibus (112b) qui est connectée à des parties d'extrémité de la pluralité d'électrodes de doigt (112a), dans lequel l'axe longitudinal de la barre omnibus (112b) s'étend perpendiculairement à l'axe longitudinal de la pluralité d'électrodes de doigt (112a).

10. Dispositif de conversion photoélectrique selon l'une quelconque des revendications précédentes, dans lequel les électrodes de doigt (112a) et/ou la barre omnibus (112b) s'étendent parallèlement aux bords du premier substrat (110).

11. Dispositif de conversion photoélectrique selon l'une quelconque des revendications précédentes, dans lequel les électrodes de doigt (112a) comprennent une forme de bande allongée, les électrodes de doigt (112a) ont une épaisseur uniforme, la barre omnibus (112b) comprend une forme de bande allongée et/ou les électrodes de doigt (112a) sont agencées de façon à être équidistantes les unes des autres.

12. Dispositif de conversion photoélectrique selon l'une quelconque des revendications précédentes, dans lequel les électrodes de doigt (112a) s'étendent sur une distance d'au moins 80 % de la distance entre les bords du premier substrat (110) qui s'étendent perpendiculairement aux électrodes de doigt (112a) et/ou dans lequel la barre omnibus (112b) s'étend sur une distance d'au moins 80 % de la distance entre les bords du premier substrat (110) qui s'étendent perpendiculairement à la barre omnibus (112b).

13. Dispositif de conversion photoélectrique selon l'une quelconque des revendications 4 à 12, dans lequel une projection des électrodes de doigt (112a) de la première électrode (113) sur le second substrat (120) le long d'un axe perpendiculaire à la surface du second substrat (120) est congruente à une projection des électrodes de doigt de la seconde électrode (223) sur le second substrat (120).

14. Dispositif de conversion photoélectrique selon l'une quelconque des revendications 4 à 13, dans lequel les électrodes de doigt (112a) de la première électrode (113) et les électrodes de doigt de la seconde électrode (223) sont formées du même matériau et/ou dans lequel les électrodes de doigt (112a) de la première électrode (113) et les électrodes de doigt de la seconde électrode (223) ont la même largeur de ligne et la même distance entre des électrodes de doigt adjacentes.

# FIG. 1

# FIG. 2

# FIG. 3

FIG. 4

# FIG. 5

# FIG. 6

# FIG. 7

RATIO OF LINE WIDTH OF GRID ELECTRODE TO
PITCH OF GRID ELECTRODE (W/P)

# FIG. 8

16

**EP 2 309 547 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20070246096 A1